Europäisches Patentamt

European Patent Office

Office européen des brevets

(11) Veröffentlichungsnummer: **0 175 356 B1**

# EUROPÄISCHE PATENTSCHRIFT

(45) Veröffentlichungstag der Patentschrift: 21.08.91

(51) Int. Cl.5: **H01H 13/70**

(21) Anmeldenummer: **85111797.8**

(22) Anmeldetag: **18.09.85**

(54) Tastatur - Folienschaltung.

(30) Priorität: **21.09.84 DE 3434664**

(43) Veröffentlichungstag der Anmeldung:
**26.03.86 Patentblatt 86/13**

(45) Bekanntmachung des Hinweises auf die
Patenterteilung:
**21.08.91 Patentblatt 91/34**

(84) Benannte Vertragsstaaten:
**FR GB IT**

(56) Entgegenhaltungen:
**US-A- 4 440 990**

(73) Patentinhaber: **Preh-Werke GmbH & Co. KG**
**Postfach 1740 An der Stadthalle**
**W-8740 Bad Neustadt/Saale(DE)**

(72) Erfinder: **Oelsch, Jürgen, Dipl.-Ing.**
**Saaleblick 23**
**W-8741 Hohenroth(DE)**

EP 0 175 356 B1

## Beschreibung

Die Erfindung betrifft eine Tastatur-Folienschaltung mit Schaltkontaktstellen, die über auf die Folie gedruckte Leiterbahnen gruppenweise zu Anschlußkontaktstellen geführt sind, wobei die Leiterbahnen in einem oder mehreren Bereichen parallel zueinander verlaufen, die Anschlußkontaktstellen und/oder die Schaltkontaktstellen aus einer Kohle-Widerstandsschicht bestehen und auf die Folie Widerstandsbahnen aufgedruckt und mit den Leiterbahnen verbunden sind.

Eine solche Folienschaltung ist aus der US-A-4 440 990 bekannt. Dabei ist die jeweilige Leiterbahn unterbrochen und die jeweilige Unterbrechungsstelle durch eine Widerstandsbahn überbrückt. Der solchermaßen in die jeweilige Leiterbahn gewollt eingebrachte elektrische Widerstand schützt die anzuschließende Elektronik gegen elektrostatische Entladung.

Bei Tastatur-Folienschaltungen stehen sich zwei Folien gegenüber, deren Schaltkontaktstellen sich decken. Über diesen sind Tasten angeordnet, deren Betätigung zu einer Kontaktierung der Schaltkontaktstellen führt.

Es hat sich gezeigt, daß das Leiterbahnmaterial wenig widerstandsfähig gegen betriebsbedingte Einflüsse im Bereich der Anschlußkontaktstellen und der Schaltkontaktstellen ist. Es werden deshalb oft die Anschlußkontaktstellen und/oder die Schaltkontaktstellen aus einer Kohle-Widerstandsschicht aufgebaut, die gegen die Beanspruchungen im Betrieb wesentlich widerstandsfähiger ist.

Bei solchen Folienschaltungen treten Koppelkapazitäten zwischen den Leiterbahnen auf. Diese wirken in manchen Fällen störend auf die angeschlossene elektronische Schaltung.

Aufgabe der Erfindung ist es, bei einer Folienschaltung der eingangs genannten Art, den Einfluß der Koppelkapazitäten der Leiterbahnen zu unterdrücken und solche Unterdrückungsmaßnahmen so zu wählen und auszulegen, daß sie mit einfachen Mitteln herstellbar sind.

Erfindungsgemäß ist obige Aufgabe bei einer Folienschaltung der eingangs genannten Art dadurch gelöst, daß die Widerstandsbahnen jeweils zwischen zwei benachbarte Leiterbahnen gedruckt und mit diesen verbunden sind und daß die Koppelkapazitäten unterdrückenden Widerstandsbahnen aus dem gleichen Kohle-Widerstandsschichtmaterial bestehen wie die Anschlußkontaktstellen bzw. die Schaltkontaktstellen.

Es wurde gefunden, daß Widerstände mit einem bestimmten Widerstandswert zwischen den Leiterbahnen eine Dämpfung der kapazitiven Kopplung bewirken. Solche Widerstände diskret oder in einem separaten Druckvorgang anzuordnen, wäre aufwendig. Nach der Erfindung bestehen die Widerstände aus dem gleichen Kohleschichtmaterial wie die Anschlußkontaktstellen bzw. die Schaltkontaktstellen. Die Schaltkontaktstellen bzw. die Anschlußkontaktstellen und die Widerstandsbahnen zwischen den Leiterbahnen lassen sich damit im gleichen Druckvorgang auf die Folie aufbringen. Es wird dabei in Kauf genommen, daß die Widerstandsbahnen relativ lang sind, weil für die Anschlußkontaktstellen bzw. die Schaltkontaktstellen eine niederohmige Widerstandspaste verwendet wird und zwischen den Leiterbahnen hochohmige Widerstände nötig sind.

Ein weiterer Vorteil besteht darin, daß die Widerstände zwischen den Leiterbahnen diese nicht kreuzen, wodurch sie einfach ohne zusätzliche Isolierschicht auf die Folie aufzudrucken sind.

In bevorzugter Ausgestaltung der Erfindung sind die Widerstandsbahnen in einem Bereich zwischen die Leiterbahnen gedruckt, in dem diese parallel zueinander verlaufen und die Widerstandsbahnen verlaufen in ihrer Längserstreckung parallel zu den Leiterbahnen, wobei jede Widerstandsbahn mit den beiden Leiterbahnen verbunden ist, zwischen denen sie verläuft. Dadurch lassen sich die Widerstandsbahnen in platzsparender Weise auf der Folie anordnen. Außerdem können die zwischen den Leiterbahnen parallel verlaufenden Widerstandsbahnen einen zusätzlichen Entkopplungseffekt mit sich bringen.

Es hat sich gezeigt, daß nicht an beiden sich gegenüberstehenden Folien der Tastatur-Folienschaltung Widerstandsbahnen vorgesehen sein müssen. Es genügt, die Widerstandsbahnen auf einer der Folien vorzusehen.

Liegen die Widerstände parallel zwischen n-Leiterbahnen, dann sind nur n-1-Widerstandsbahnen nötig.

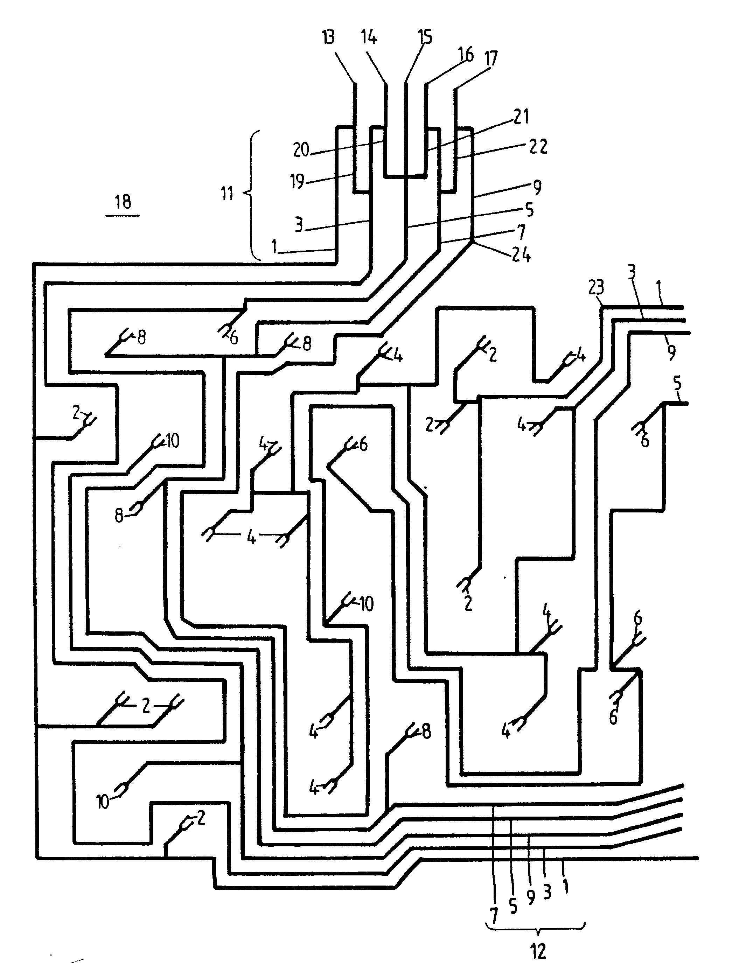

Weitere vorteilhafte Ausgestaltungen der Erfindung ergeben sich aus der folgenden Beschreibung eines Ausführungsbeispiels. Die Figur zeigt eine mit Leiterbahnen und Widerstandsbahnen bedruckte Folie einer Tastatur-Folienschaltung, abgebrochen.

Eine Leiterbahn 1 führt zu Schaltkontaktstellen 2. Eine Leiterbahn 3 führt zu Schaltkontaktstellen 4. Eine Leiterbahn 5 führt zu Schaltkontaktstellen 6. Eine Leiterbahn 7 führt zu Schaltkontaktstellen 8. Eine Leiterbahn 9 führt zu Schaltkontaktstellen 10. Da in der Figur die Folie abgebrochen dargestellt ist, sind jeweils nur einige der Schaltkontaktstellen zu sehen.

Die Leiterbahnen 1, 3, 5, 7 und 9 verlaufen in Bereichen 11 und 12 parallel. Jede Leiterbahn 1, 3, 5, 7 und 9 läuft an einer Kontaktstelle 13 bis 17 aus. Der Abstand der Anschlußkontaktstellen 13 bis 17 entspricht dem Raster einer üblichen Anschlußleiste.

Die Leiterbahnen 1, 3, 5, 7 und 9 bestehen aus einer auf die Folie 18 aufgedruckten Silberleitpaste. Die Schaltkontaktstellen 2, 4, 6, 8, 10 und die Anschlußkontaktstellen 13 bis 17 sind aus einer niederohmigen Widerstandspaste auf die Folie 18 aufgedruckt.

Im Bereich 11 sind zwischen die Leiterbahnen 1, 3, 5, 7 und 9 Widerstandsbahnen 19, 20, 21 und 22 aus dieser Widerstandspaste aufgedruckt. Die Widerstandsbahnen 19 bis 22 liegen in ihrer Längserstreckung parallel zu den Leiterbahnen 1, 3, 5, 7 und 9. Die Widerstandsbahn 19 ist an ihrem einen Ende mit der Leiterbahn 1 und an ihrem anderen Ende mit der Leiterbahn 3 verbunden. Entsprechendes gilt für die weiteren Widerstandsbahnen. Der Widerstandswert jeder Widerstandsbahn liegt beispielsweise bei 9 kΩ. Die Widerstandsbahnen 19 bis 22 sind lang im Vergleich zu den Schaltkontaktstellen 2, 4, 6, 8 und 10 und den Anschlußkontaktstellen 13 bis 17.

Widerstandsbahnen der genannten Art ließen sich auch zusätzlich oder alternativ in dem Bereich 12 anordnen.

Da die einen Enden der Widerstandsbahnen 19, 20, 21 und 22 den Anschlußkontaktstellen 13, 14, 16 und 17 ohnehin sehr nahe liegen, können diese Anschlußkontaktstellen und die Widerstandsbahnen durchgehend gedruckt sein, ohne daß zwischen den Anschlußkontaktstellen und den Widerstandsbahnen Leiterbahnabschnitte bestehen. Die Leiterbahnen zweigen dann direkt von der durchgehenden Widerstandsbahn ab.

Zwischen den äußeren Leiterbahnen 1 und 9 liegt elektrisch die Reihenschaltung der Widerstandsbahnen 19 bis 22. Ist ein zusätzlicher Widerstand zwischen den Leiterbahnen 1 und 9 erwünscht, dann kann dieser kreuzungsfrei zwischen der Stelle 23 der Leiterbahn 1 und der Stelle 24 der Leiterbahn 9 vorgesehen sein.

Mit der beschriebenen Widerstandsanordnung ist der Einfluß von Koppelkapazitäten der Folientastatur auf eine an die Anschlußkontaktstellen angeschlossenen elektronischen Schaltung unterdrückt.

## Patentansprüche

1. Tastatur-Folienschaltung mit Schaltkontaktstellen (2, 4, 6, 8, 10), die über auf die Folie (18) gedruckte Leiterbahnen (1, 3, 5, 7, 9) gruppenweise zu Anschlußkontaktstellen (13 bis 17) geführt sind, wobei die Leiterbahnen (1, 3, 5, 7, 9) in einem oder mehreren Bereichen (11, 12) parallel zueinander verlaufen, die Anschlußkontaktstellen (13 bis 17) und/oder die Schaltkontaktstellen (2, 4, 6, 8, 10) aus einer Kohle-Widerstandsschicht bestehen und auf die Folie (18) Widerstandsbahnen (19 bis 22) aufgedruckt und mit den Leiterbahnen (1, 3, 5, 7, 9) verbunden sind,

dadurch gekennzeichnet,
daß die Widerstandsbahnen (19 bis 22) jeweils zwischen zwei benachbarte Leiterbahnen (1, 3, 5, 7, 9) gedruckt und mit diesen verbunden sind und
daß die Koppelkapazitäten unterdrückenden Widerstandsbahnen (19 bis 22) aus dem gleichen Kohle-Widerstandsschichtmaterial bestehen wie die Anschlußkontaktstellen (13 bis 17) bzw. die Schaltkontaktstellen (2, 4, 6, 8, 10).

2. Tastatur-Folienschaltung nach Anspruch 1, dadurch gekennzeichnet,
daß die Widerstandsbahnen (19 bis 22) in einem Bereich (11, 12) zwischen die Leiterbahnen (1, 3, 5, 7, 9) gedruckt sind, in dem diese parallel zueinander verlaufen, und
daß die Widerstandsbahnen (19 bis 22) in ihrer Längserstreckung parallel zu den Leiterbahnen (1, 3, 5, 7, 9) verlaufen.

3. Tastatur-Folienschaltung nach Anspruch 1 oder 2,
dadurch gekennzeichnet,
daß die Widerstandsbahnen (19 bis 22) in dem an die Anschlußkontaktstellen (13 bis 17) angrenzenden Leiterbahnbereich (11) angeordnet sind.

4. Tastatur-Folienschaltung nach Anspruch 3, dadurch gekennzeichnet,
daß die Widerstandsbahnen (19 bis 22) und die Anschlußkontaktstellen (13, 14, 16, 17) direkt ineinander übergehen.

## Claims

1. Keyboard membrane circuit having switching contact points (2, 4, 6, 8, 10), which are conducted in groups to connection contact points (13 to 17) by means of printed conductors (1, 3, 5, 7, 9) printed on to the membrane (18), wherein the printed conductors (1, 3, 5, 7, 9) extend in parallel with one another in one or several regions (11, 12), the connection contact points (13 to 17) and/or the switching contact points (2, 4, 6, 8, 10) consist of a carbon resistance layer and resistance paths (19 to 22) are printed on to the membrane (18) and are connected to the printed conductors (1, 3, 5, 7, 9),
characterized in that
the resistance paths (19 to 22) are each printed between two adjacent printed conductors (1, 3, 5, 7, 9) and are connected to these and the resistance paths (19 to 22) suppressing the coupling capacitances consist of the same carbon resistance layer material as the connection contact points (13 to 17) or the switching contact points (2, 4, 6, 8, 10).

2. Keyboard membrane circuit according to claim 1, characterized in that
the resistance paths (19 to 22) are printed in a region (11, 12) between the printed conductors (1, 3, 5, 7, 9), in which the latter extend in parallel with one another, and
the resistance paths (19 to 22) in their longitudinal extent run parallel to the printed conductors (1, 3, 5, 7, 9).

3. Keyboard membrane circuit according to claim 1 or 2, characterized in that
the resistance paths (19 to 22) are arranged in the printed conductor region (11) adjoining the connection contact points (13 to 17).

4. Keyboard membrane circuit according to claim 3, characterized in that the resistance paths (19 to 22) and the connection contact points (13, 14, 16, 17) merge into one another directly.

**Revendications**

1. Circuit de clavier sur feuilles minces, comportant des emplacements (2, 4, 6, 8, 10) de contact de commutation qui sont raccordés par groupes à des emplacements (13 à 17) de contact de connexion, par l'intermédiaire de pistes conductrices (1, 3, 5, 7, 9) imprimées sur la feuille mince (18), les pistes conductrices (1, 3, 5, 7, 9) s'étendant parallèlement les unes aux autres dans une ou plusieurs zones (11, 12), les emplacements (13 à 17) de contact de connexion et/ou les emplacements (2, 4, 6, 8, 10) de contact de commutation étant constitués par une couche résistante de carbone et des pistes résistantes (19 à 22) étant imprimées sur la feuille mince (18) et étant connectées aux pistes conductrices (1, 3, 5, 7, 9), circuit caractérisé en ce que les pistes résistantes (19 à 22) sont dans chaque cas imprimées entre deux pistes conductrices (1, 3, 5, 7, 9) voisines et sont connectées à celles-ci, et en ce que les pistes résistantes (19 à 22), qui atténuent les capacités de couplage, sont constituées par le même matériau de couche résistante, en carbone, que les emplacements (13 à 17) de contact de connexion, ou que les emplacements (2, 4, 6, 8, 10) de contact de commutation.

2. Circuit de clavier sur feuilles minces, caractérisé en ce que les pistes résistantes (19 à 22) sont imprimées dans une zone (11, 12) entre les pistes conductrices (1, 3, 5, 7, 9) en s'étendant parallèlement les unes aux autres, et en ce que les pistes résistantes (19 à 22) s'étendent, dans le sens de leur longueur, parallèlement aux pistes conductrices (1, 3, 5, 7, 9).

3. Circuit de clavier sur feuilles minces selon la revendication 1 ou 2, caractérisé en ce que les pistes résistantes (19 à 22) sont disposées dans la zone (11) des pistes conductrices située au voisinage immédiat des emplacements (13 à 17) de contact de connexion.

4. Circuit de clavier sur feuilles minces selon la revendication 3, caractérisé en ce qu'il n'y a pas de transition entre les pistes résistantes (19 à 22) et les emplacements (13, 14, 16, 17) de contact de connexion et en ce qu'on passe directement des un(e)s aux autres.